# EUROPÄISCHE PATENTSCHRIFT

(11) **EP 2 872 825 B1**
(45) Veröffentlichungstag und Bekanntmachung des Hinweises auf die Patenterteilung: **23.11.2016**
(21) Anmeldenummer: 13734034.5
(22) Anmeldetag: 28.06.2013
(51) Int. Cl.: F21Y 115/10, F21Y 105/00, F21V 23/00

(54) **LEUCHTMODUL**
LIGHTING MODULE
MODULE D'ÉCLAIRAGE

(30) Priorität: 10.07.2012 DE 102012212025
(43) Veröffentlichungstag der Anmeldung: 20.05.2015
(73) Patentinhaber: OSRAM GmbH, 80807 München (DE)
(72) Erfinder: PREUSCHL, Thomas, 93161 Sinzing (DE); HOETZL, Guenter, 93049 Regensburg (DE); SACHSENWEGER, Peter, 93197 Zeitlarn (DE)
(86) Internationale Anmeldenummer: PCT/EP2013/063745
(87) Internationale Veröffentlichungsnummer: WO 2014/009181

(56) Entgegenhaltungen:
- EP-A2- 2 455 655
- WO-A1-2012/055852
- DE-U1-202011 107 787
- JP-A- 2012 074 250
- US-B1- 6 502 968

## Beschreibung

Die Erfindung betrifft ein Leuchtmodul.

Derartige Leuchtmodule umfassen meist eine Leiterplatte, an deren Oberseite eine oder mehrere Lichtquellen angeordnet sind, sowie ein Abdeckelement, welches die Leiterplatte zumindest teilweise abdeckt. Zusätzlich ist es üblicherweise vorgesehen, dass die Leuchtmodule einen externen Treiber bzw. ein Vorschaltgerät aufweisen, in welchen ein oder mehrere elektronische Bauelemente, die zum Betrieb der Lichtquellen auf der Leiterplatte notwendig sind, angeordnet sind. Diese ein oder mehreren elektronischen Bauelement sind mit der ein oder mehrere Lichtquellen aufweisenden Leiterplatte verbunden. Durch einen derartigen externen Treiber bzw. ein derartiges externes Vorschaltgerät ist ein großer Bauraum für das Leuchtmodul, insbesondere in einer Beleuchtungseinrichtung, notwendig.

Die EP 2 455 655 A1 sowie die DE 20 2011 107787 U1 zeigen Beleuchtungsvorrichtungen, mit Anordnungen von Leiterplatten und elektrischen Bauelementen sowie Lichtquellen Gehäusen.

Verschiedene Ausführungsformen stellen ein Leuchtmodul und ein Verfahren zur Montage eines Leuchtmoduls zur Verfügung, bei welchen eine kompaktere Ausgestaltung des Leuchtmoduls erzielt werden kann.

In verschiedenen Ausführungsformen kann ein Leuchtmodul aufweisen: eine erste Leiterplatte, an welcher mindestens eine Lichtquelle angeordnet ist, ein Abdeckelement, welches die erste Leiterplatte zumindest teilweise abdeckt, und eine zweite Leiterplatte, an welcher mindestens ein elektronisches Bauelement angeordnet ist, wobei die zweite Leiterplatte an dem Abdeckelement befestigt ist und mit der ersten Leiterplatte elektrisch verbunden ist.

Vorteilhafte Ausführungen und zweckmäßige Weiterbildungen der Erfindung sind in den Unteransprüchen angegeben.

Ein derartiges Leuchtmodul weist den Vorteil auf, dass die sonst üblicherweise in einem zusätzlichen Treiber oder einem zusätzlichen Vorschaltgerät angeordnete zweite Leiterplatte, welche mit einem oder mehreren elektronischen Bauelementen bestückt ist, nunmehr unmittelbar in dem Abdeckelement, welches die mit der Lichtquelle bestückte erste Leiterplatte abdeckt, angeordnet ist, indem die zweite Leiterplatte an einer Innenfläche, insbesondere an einer Innenfläche einer Deckenwandung, des Abdeckelementes befestigt ist und damit parallel zur ersten Leiterplatte, insbesondere oberhalb der ersten Leiterplatte, angeordnet ist. Die zweite Leiterplatte ist im Bereich der ein oder mehreren elektronischen Bauelemente beabstandet zu der Innenfläche der Deckenwandung des Abdeckelementes angeordnet, so dass die ein oder mehreren an der zweiten Leiterplatte angeordneten elektronischen Bauelemente zwischen der zweiten Leiterplatte und der Innenfläche der Deckenwandung des Abdeckelementes positioniert sein können. Dadurch kann erreicht werden, dass bei einer Anordnung von elektronischen Bauteilen an der ersten Leiterplatte die zweite Leiterplatte als eine Art Isolierschicht zwischen den an der ersten Leiterplatte angeordneten elektronischen Bauteilen und den an der zweiten Leiterplatte angeordneten elektronischen Bauelementen dient, da die zweite Leiterplatte zwischen den elektronischen Bauteilen und den elektronischen Bauelementen angeordnet ist. Bei einer derartigen Ausbildung ist es ferner vorteilhaft, dass das Abdeckelement aus einem Standardmaterial, insbesondere einem Standardkunststoff, ausgebildet sein kann, da die mit den elektronischen Bauelementen bestückte zweite Leiterplatte als zusätzliches Bauteil zu dem Abdeckelement vorgesehen ist und lediglich in das Abdeckelement eingesetzt ist. An das Material des Abdeckelementes müssen daher keine besonderen Anforderungen gestellt werden. Ferner können durch diese Ausbildung das oder die an der zweiten Leiterplatte angeordneten elektronischen Bauelemente besonders platzsparend in dem Leuchtmodul angeordnet werden, wodurch das gesamte Leuchtmodul kompakter ausgebildet werden kann und dadurch einen geringeren Bauraum als herkömmliche Leuchtmodule bei einem Einbau in eine Beleuchtungseinrichtung benötigt, wodurch auch eine größere Designfreiheit für die Beleuchtungseinrichtung erreicht werden kann. Ferner kann hierdurch die gesamte Montage des Leuchtmoduls für einen Benutzer wesentlich vereinfacht werden, da der Benutzer zur Inbetriebnahme des Leuchtmoduls lediglich die Netzspannung anschließen muss. An der zweiten Leiterplatte können ein oder mehrere elektronische Bauelemente angeordnet sein, wobei bei mehreren elektronischen Bauelementen der gleichen Funktion elektronische Bauelemente mit unterschiedlichen Leistungen miteinander kombiniert werden können, wodurch die Eigenschaften des Leuchtmoduls individuell eingestellt und angepasst werden können.

Die zweite Leiterplatte ist als eine flexible Leiterplatte ausgebildet. Eine flexible Leiterplatte zeichnet sich dadurch aus, dass sie biegbar bzw. faltbar ist, so dass ihre Form individuell an die Einbauverhältnisse innerhalb des Abdeckelementes angepasst werden kann. Insbesondere kann die zweite Leiterplatte hierdurch derart gebogen werden, dass eine möglichst einfache, kurze Anbindung zwischen der zweiten Leiterplatte und der ersten Leiterplatte möglich ist. Ferner kann durch die Biegbarkeit der Leiterplatte diese in ihrer Grundposition, bevor Sie auf die an das Abdeckelement passende Größe gebogen wird, eine größere Fläche als der Durchmesser des Abdeckelementes aufweisen, so dass mittels der zweiten Leiterplatte eine Luft- und Kriechstreckenverlängerung zwischen den an der zweiten Leiterplatte angeordneten elektronischen Bauelementen und der ersten Leiterplatte ausgebildet werden kann. Gegenüber herkömmlichen Leiterplatten zeichnet sich eine flexible Leiterplatte zudem durch ein geringeres Gewicht aus, wodurch das Gesamtgewicht des Leuchtmoduls gegenüber herkömmlichen Leuchtmodulen verringert werden kann. Beispielsweise kann die flexible Leiterplatte aus einem Polyimid ausgebildet sein.

Die zweite Leiterplatte ist mit der ersten Leiterplatte beispielsweise mittels einer Schweißverbindung oder einer Lötverbindung elektrisch verbunden. Mittels einer Schweiß- oder Lötverbindung kann eine sichere, stabile Verbindung mit einer gleichzeitig guten Leitfähigkeit zwischen den beiden Leiterplatten ausgebildet werden. Zudem zeichnet sich eine Schweiß- oder Lötverbindung zum Verbinden der beiden Leiterplatten miteinander durch eine geringere Fehleranfälligkeit aus, als dies bei anderen Verbindungsarten der Fall ist. Es ist aber auch möglich, die beiden Leiterplatten auf eine andere Art und Weise, beispielsweise einem Feder- und/oder Klemmkontakt, miteinander elektrisch zu verbinden.

Um die Ausbildung der elektrischen Verbindung zwischen der zweiten Leiterplatte und der ersten Leiterplatte zu vereinfachen, weist die zweite Leiterplatte eine erste Anschlusslasche auf . Diese erste Anschlusslasche kann an einer Außenumfangsfläche eines Grundkörpers der zweiten Leiterplatte, an welchem die elektronischen Bauelemente angeordnet sind, ausgebildet sein, wobei die Anschlusslasche entsprechend gebogen, vorzugsweise L-förmig gebogen, ist, um zumindest teilweise auf der ersten Leiterplatte aufliegen zu können und damit beispielsweise durch eine Schweiß- oder Lötverbindung eine direkte Kontaktierung zwischen den beiden Leiterplatten ausbilden zu können. Ist die zweite Leiterplatte eine flexible Leiterplatte kann die erste Anschlusslasche bei der Montage des Leuchtmoduls entsprechend gebogen werden, um eine individuell angepasste Verbindung mit der ersten Leiterplatte zu erreichen.

Ferner ist es möglich, dass die zweite Leiterplatte eine zweite Anschlusslasche aufweist, an welcher ein Netzanschluss angeordnet ist. Diese zweite Anschlusslasche kann ebenfalls an der Außenumfangsfläche des Grundkörpers der zweiten Leiterplatte, an welchem die elektronischen Bauelemente angeordnet sind, ausgebildet sein, wobei die zweite Anschlusslasche beispielsweise der ersten Anschlusslasche an dem Grundkörper gegenüberliegt. Über die zweite Anschlusslasche kann der als beispielsweise Modulstecker ausgebildete Netzanschluss in dem Leuchtmodul integriert werden, wobei durch die Anordnung des Netzanschlusses an der zusätzlich zu dem Grundkörper ausgebildeten zweiten Anschlusslasche der auf der Leiterplatte für die elektronischen Bauelemente zur Verfügung gestellte Platz durch die zusätzliche Anordnung des Netzanschlusses nicht reduziert wird. Die zweite Anschlusslasche ist beispielsweise abgewinkelt zu dem Grundkörper der Leiterplatte ausgebildet, wobei die zweite Anschlusslasche beispielsweise in eine entgegengesetzte Richtung zu der ersten Anschlusslasche von dem Grundkörper abgewinkelt ausgebildet ist. Insbesondere kann die zweite Anschlusslasche, im Gegensatz zu der ersten Anschlusslasche, von der ersten Leiterplatte weggebogen sein. Ist die zweite Leiterplatte eine flexible Leiterplatte kann die zweite Anschlusslasche bei der Montage des Leuchtmoduls entsprechend gebogen werden.

Das mindestens eine an der zweiten Leiterplatte angeordnete elektronische Bauelement kann beispielsweise eine oberflächenmontierte Komponente (SMD = Surface Mounted Device) sein. Als oberflächenmontierte Komponente weist das elektronische Bauelement eine lötfähige Anschlussfläche auf, mittels welcher das elektronische Bauelement unmittelbar auf die Leiterplatte gelötet werden kann. Hierdurch ist bei mehreren elektronischen Bauelementen eine besonders dichte Bestückung auf der Leiterplatte möglich, wodurch der Platzbedarf der elektronischen Bauelemente reduziert und damit das gesamte Leuchtmodul kompakter ausgebildet werden kann. Zudem kann die Bestückung der Leiterplatte mit elektronischen Bauelementen besonders schnell erfolgen, wodurch die Montagezeit des gesamten Leuchtmoduls reduziert werden kann.

Die Befestigung der zweiten Leiterplatte an dem Abdeckelement kann mittels einer Schweißverbindung, einer Klebverbindung und/oder einer Einrastverbindung erfolgen, wodurch eine sichere und stabile Befestigung zwischen der zweiten Leiterplatte und dem Abdeckelement ausgebildet werden kann. Die Schweißverbindung kann insbesondere durch ein Kunststoff-Laserschweißen ausgebildet werden.

Das elektronische Bauelement ist beispielsweise ein Kondensator, welcher insbesondere dazu dient, Versorgungsspannungen der Lichtquelle zu glätten, elektromagnetische Interferenzen herauszufiltern und Geräuschentwicklungen zu reduzieren. Bei der Anordnung von mehreren Kondensatoren als elektronische Bauelemente in dem Abdeckelement kann durch eine gezielte Auswahl der Anzahl der Kondensatoren das Modulationsverhalten, d. h. das sogenannte "Flackern", der Lichtquelle eingestellt, insbesondere reduziert, werden. Das elektronische Bauelement kann jedoch neben der Ausgestaltung als Kondensator auch eine andere Funktion aufweisen, beispielsweise indem dieses als ein Widerstand ausgebildet ist.

Ist das elektronische Bauelement ein Kondensator, so ist der Kondensator beispielsweise aus einem Keramikmaterial ausgebildet. Bei der Ausbildung des Kondensators aus einem Keramikmaterial kann dieser eine gegenüber einem herkömmlichen Elektrolytkondensator kleinere Bauform aufweisen, wodurch der Kondensator einen geringeren Bauraum benötigt und dadurch die Abmessungen des gesamten Leuchtmoduls weiter reduziert werden können. Es ist aber auch möglich, als Kondensator einen Elektrolytkondensator zu verwenden, wobei durch die Anordnung des Elektrolytkondensators in dem Abdeckelement der Abstand zur Wärmequelle gegenüber der Anordnung in einem externen Treiber erhöht werden kann, wodurch die Lebensdauer des Elektrolytkondensators gegenüber der Anordnung in einem herkömmlichen Leuchtmodul erhöht werden kann.

Um zu verhindern, dass das Abdeckelement sich von der ersten Leiterplatte ungewollt lösen kann und dadurch kein Berührschutz durch das Abdeckelement mehr gegeben wäre, kann das Abdeckelement mit der Leiterplatte lösbar oder unlösbar verbunden sein. Durch die lösbare oder unlösbare Verbindung ist das Abdeckelement durch Formschluss und/oder Kraftschluss und/oder Stoffschluss fest mit der ersten Leiterplatte verbunden, wobei die Verbindung beispielsweise durch eine Klemmverbindung, eine Klebverbindung oder eine Heißverstemmverbindung ausgebildet sein kann.

Die Lichtquelle kann beispielsweise eine Leuchtdiode (LED) sein, wobei die Leuchtdiode auch eine organische Leuchtdiode (OLED) sein kann. Sind mehr als eine Lichtquelle und damit mehr als eine Leuchtdiode in dem Leuchtmodul angeordnet, können diese derart ausgewählt sein, dass sie in der gleichen Farbe oder in verschiedenen Farben leuchten.

Ein Verfahren zur Montage eines Leuchtmoduls kann beispielsweise derart erfolgen, dass an einer ersten Leiterplatte mindestens eine Lichtquelle angeordnet wird, an einer zweiten Leiterplatte mindestens ein elektronische Bauelement angeordnet wird, die mit dem mindestens einen elektronischen Bauelement bestückte zweite Leiterplatte an einem Abdeckelement befestigt wird, die zweite Leiterplatte mit der ersten Leiterplatte elektrisch verbunden wird, und das Abdeckelement auf die erste Leiterplatte derart aufgesetzt wird, dass das Abdeckelement die erste Leiterplatte zumindest teilweise abdeckt.

Ein Ausführungsbeispiel der Erfindung ist in den Figuren dargestellt und wird im Folgenden näher erläutert.

Es zeigen
- Figur 1: eine schematische Schnittdarstellung eines Leuchtmoduls;
- Figur 2: eine schematische Darstellung eines Montageschrittes zur Ausbildung eines wie in Figur 1 gezeigten Leuchtmoduls;
- Figur 3: eine schematische Darstellung eines weiteren Montageschrittes zur Ausbildung eines wie in Figur 1 gezeigten Leuchtmoduls;
- Figur 4: eine schematische Darstellung eines weiteren Montageschrittes zur Ausbildung eines wie in Figur 1 gezeigten Leuchtmoduls;
- Figur 5: eine schematische Darstellung eines weiteren Montageschrittes zur Ausbildung eines wie in Figur 1 gezeigten Leuchtmoduls;
- Figur 6: eine schematische Darstellung eines weiteren Montageschrittes zur Ausbildung eines wie in Figur 1 gezeigten Leuchtmoduls; und
- Figur 7: eine schematische Darstellung eines weiteren Montageschrittes zur Ausbildung eines wie in Figur 1 gezeigten Leuchtmoduls.

In der folgenden ausführlichen Beschreibung wird auf die beigefügten Zeichnungen Bezug genommen, die Teil dieser bilden und in denen zur Veranschaulichung eine spezifische Ausführungsform gezeigt ist, in der die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Die folgende ausführliche Beschreibung ist nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

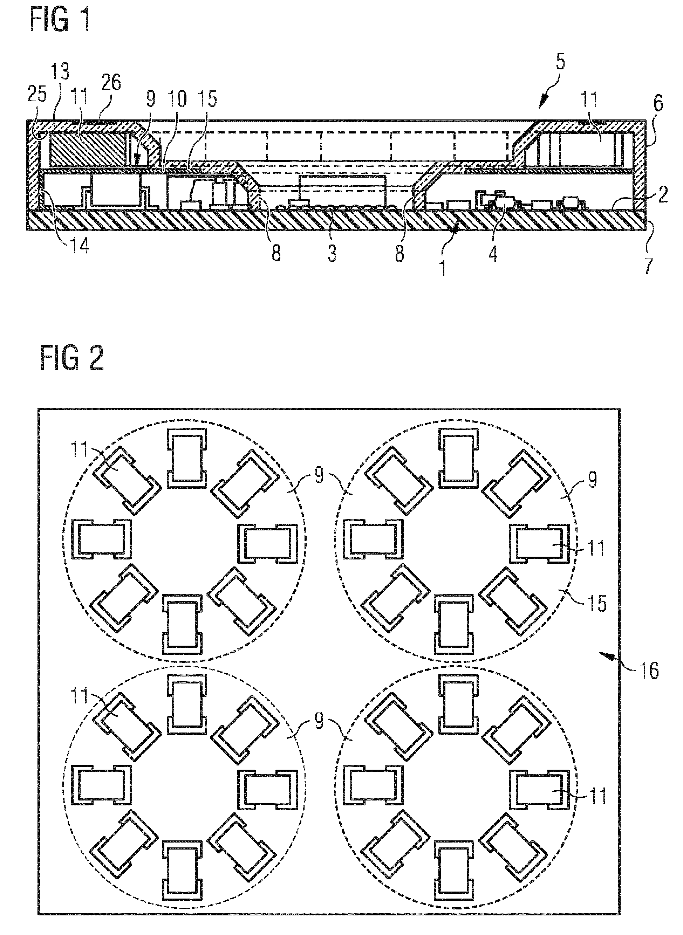

In Figur 1 ist ein Leuchtmodul gezeigt, welches eine im Wesentlichen kreisscheibenförmige erste Leiterplatte 1 aufweist, welche an ihrer Oberseite 2 mit mehreren Lichtquellen 3 in Form von Leuchtdioden bestückt ist. Die Lichtquellen 3 sind mittig auf der Leiterplatte 1, in einem gleichmäßigen Abstand zueinander, kompakt angeordnet. Zusätzlich sind auf der Oberseite 2 der ersten Leiterplatte 1 mehrere elektronische Bauteile 4 angeordnet. Die elektronischen Bauteile 4 können als SMD-Komponenten (SMD = Surface Mounted Device (oberflächenmontiertes Bauelement)) ausgebildet sein, welche mittels lötfähiger Anschlussflächen direkt auf die Leiterplatte 1 gelötet werden. Die elektronischen Bauteile 4 sind kreisförmig um die Lichtquellen 3 herum angeordnet. Die erste Leiterplatte 1 bildet mit den Lichtquellen 3 und den elektronischen Bauteilen 4 eine sogenannte "Lightengine" aus.

Ferner weist das Leuchtmodul ein ringförmiges Abdeckelement 5 auf, welches haubenförmig ausgebildet ist und auf die erste Leiterplatte 1 aufgesetzt ist, so dass die Außenumfangsfläche 6 des Abdeckelementes 5 bündig mit der Außenkante 7 der ersten Leiterplatte 1 abschließt. Das Abdeckelement 5 ist derart ausgebildet, dass es die elektronischen Bauteile 4 auf der ersten Leiterplatte 1 überdeckt, das Abdeckelement 5 die erste Leiterplatte 1 jedoch im Bereich der Lichtquellen 3 nicht überdeckt, sondern das Abdeckelement 5 eine durch eine nach außen gerichtete Innenumfangsfläche 8 begrenzte Freimachung aufweist. Somit überdeckt das Abdeckelement 5 die erste Leiterplatte 1 zwischen ihrer kreisförmigen Außenumfangsfläche 6 und ihrer kreisförmigen Innenumfangsfläche 8, wobei das Abdeckelement 5 sowohl mit ihrer Außenumfangsfläche 6 als auch mit ihrer Innenumfangsfläche 8 auf der Oberseite 2 der ersten Leiterplatte 1 aufliegt.

Das Leuchtmodul weist ferner eine zweite Leiterplatte 9 auf, welche oberhalb der ersten Leiterplatte 1, parallel zu der ersten Leiterplatte 1 angeordnet ist. Auf der Oberseite 10 der zweiten Leiterplatte 9, welche von der ersten Leiterplatte 1 weggerichtet ist, sind mehrere elektronische Bauelemente 11 in Form von SMD-Komponenten befestigt. Die elektronischen Bauelemente 11 sind bei der hier gezeigten Ausführungsform aus einem Keramikmaterial ausgebildete Kondensatoren, die bei herkömmlichen Leuchtmodulen in Form von Elektrolytkondensatoren ausgebildet und in einem externen Treiber oder einem externen Vorschaltgerät angeordnet sind. Die als Keramikkondensatoren ausgebildeten elektronischen Bauelemente 11 dienen insbesondere dazu, Versorgungsspannungen der Lichtquellen 3 zu glätten, elektromagnetische Interferenzen herauszufiltern und Geräuschentwicklungen zu reduzieren.

Die zweite Leiterplatte 9, welche hier als eine flexible Leiterplatte ausgebildet ist, ist an einer in Richtung erste Leiterplatte 1 zeigenden Innenfläche 25 einer Deckenwandung 13 des Abdeckelementes 5 befestigt, wobei die Deckenwandung 13 des Abdeckelementes 5 derart geformt ist, dass im Bereich der elektronischen Bauelemente 11 die Oberseite 10 der zweiten Leiterplatte 9 beabstandet zu der Innenfläche 25 der Deckenwandung 13 des Abdeckelementes 5 angeordnet ist, so dass die an der zweiten Leiterplatte 9 angeordneten elektronischen Bauelemente 11 zwischen der zweiten Leiterplatte 9 und der Innenfläche 25 der Deckenwandung 13 des Abdeckelementes 5 angeordnet sind. Zwischen den an der ersten Leiterplatte 1 angeordneten elektronischen Bauteilen 4 und den an der zweiten Leiterplatte 9 angeordneten elektronischen Bauelementen 11 ist somit die zweite Leiterplatte 9 angeordnet, so dass die zweite Leiterplatte 9 eine Isolierschicht zwischen den elektronischen Bauteilen 4 und den elektronischen Bauelementen 11 ausbildet.

Zur Ausbildung einer elektrischen Verbindung zwischen der ersten Leiterplatte 1 und der zweiten Leiterplatte 9 ist an der zweiten Leiterplatte 9 eine erste Anschlusslasche 14 ausgebildet, welche von dem Grundkörper 15 der zweiten Leiterplatte 9, an welchem die elektronischen Bauelemente 11 angeordnet sind, L-förmig in Richtung der ersten Leiterplatte 1 nach unten weggebogen ist und dadurch auf der ersten Leiterplatte 1 zumindest teilweise aufliegt. Dort, wo die erste Anschlusslasche 14 auf der ersten Leiterplatte 1 aufliegt, kann die erste Anschlusslasche 14 beispielsweise über eine Schweiß- oder Lötverbindung mit der ersten Leiterplatte 1 verbunden werden, wodurch eine elektrische Verbindung zwischen der ersten Leiterplatte 1 und der zweiten Leiterplatte 9 ausgebildet wird.

In Figur 2 bis Figur 7 ist ein Verfahren zur Montage eines wie in Figur 1 gezeigten Leuchtmoduls schematisch mit den einzelnen Herstellungs- und Montageschritten gezeigt.

Aus einem großflächigen Leiterplattenpaneel 16, wie es in Figur 2 gezeigt ist, können mehrere zweite Leiterplatten 9 zur Herstellung mehrerer Leuchtmodule ausgeformt werden, wobei vor der Ausformung der zweiten Leiterplatten 9, beispielsweise durch Stanzen aus dem Leiterpaneel 16, die zweiten Leiterplatten 9 mit elektronischen Bauelementen 11, hier beispielsweise mit jeweils acht elektronischen Bauelementen 11, bestückt werden, indem diese als SMD-Komponenten durch eine Oberflächenmontage, bei welcher eine lötfähige Anschlussfläche der elektronischen Bauelemente 11 direkt auf die hier bereits vorgestanzten Leiterplatten 9, durch die kreisförmigen Strichlinien angedeutet, einen Kreis bildend aufgelötet werden.

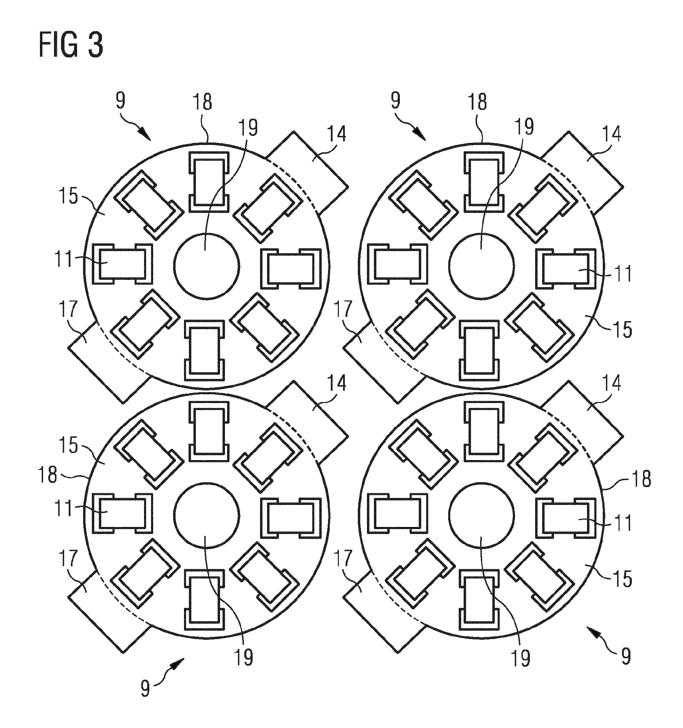

Anschließend werden, wie in Figur 3 gezeigt ist, die einzelnen zweiten Leiterplatten 9 aus dem Leiterplattenpaneel 16 ausgestanzt, wobei diese derart ausgestanzt werden, dass an dem kreisförmigen Grundkörper 15 der Leiterplatten 9 jeweils eine erste Anschlusslasche 14 und eine zweite Anschlusslasche 17 angeformt ist, welche hier rechteckförmig ausgebildet sind. Die beiden Anschlusslaschen 14, 17 sind an der Außenumfangsfläche 18 des Grundkörpers 15 angeformt und liegen sich gegenüber. Die Anschlusslaschen 14, 17 sind demzufolge aus dem gleichen Material ausgebildet wie der Grundkörper 15 der zweiten Leiterplatte 9. Dadurch, dass die zweite Leiterplatte 9 hier eine flexible Leiterplatte ist, können die Anschlusslaschen 14, 17 flexibel in die gewünschte Form gebogen oder gefaltet werden.

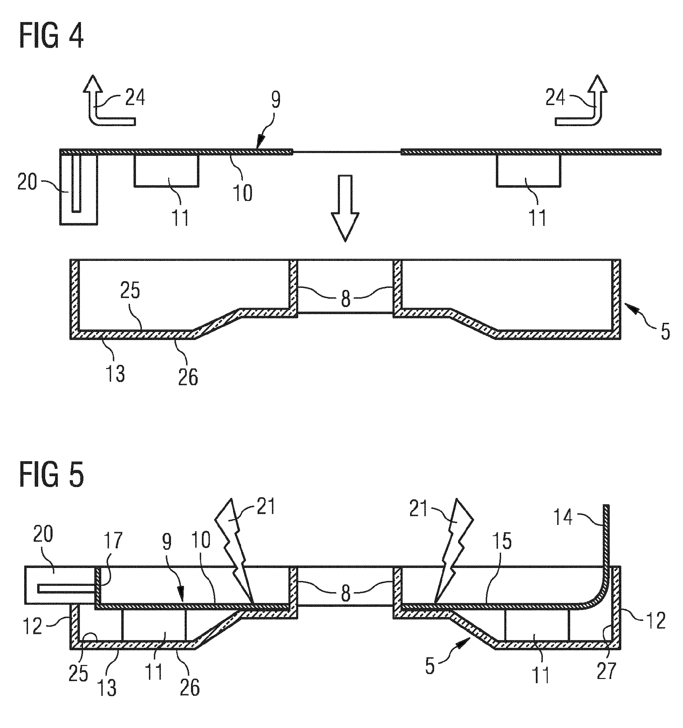

Auf der zweiten Anschlusslasche 18 wird ein als Modulstecker ausgebildeter Netzanschluss 20, wie er in Figur 4 gezeigt ist, montiert, wobei der Netzanschluss 20 ebenfalls als SMD-Komponente mittels einer Oberflächenmontage, bei welcher eine lötfähige Anschlussfläche des Netzanschlusses 20 direkt auf die zweite Anschlusslasche 18 aufgelötet wird, auf der zweiten Anschlusslasche 18 befestigt wird. Alternativ ist es beispielsweise auch möglich, den Modulstecker als Nullkraft-Stecker (Zero Insertion Force - Stecker) auszubilden und an der zweiten Anschlusslasche 18 zu befestigen.

Wie in Figur 3 weiter zu erkennen ist, weisen die zweiten Leiterplatten 9 mittig an ihrem Grundkörper 15 eine Durchgangsöffnung 19 auf, welche ebenfalls durch Stanzen ausgebildet werden kann. Die Durchgangsöffnung 19 ist im Bereich der Lichtquellen 3 der Leiterplatte 1 ausgebildet, so dass aus den Lichtquellen 3 emittiertes Licht ungehindert die zweite Leiterplatte 9 passieren und aus dem Leuchtmodul ausstrahlen kann. Der Grundkörper 15 bzw. die zweite Leiterplatte 9 ist somit ringförmig ausgebildet.

In Figur 4 wird die Montage der mit den elektronischen Bauelementen 11 bestückten zweiten Leiterplatte 9 in dem Abdeckelement 5 gezeigt. Die zweite Leiterplatte 9 wird dabei in das hier auf einer Außenseite 26 der Deckenwandung 13 liegende Abdeckelement 5 eingelegt, wobei die zwei Anschlusslaschen 14, 17, wie mit den Pfeilen 24 angedeutet, nach oben, von dem Abdeckelement 5 weg, gebogen werden.

In Figur 5 ist die zweite Leiterplatte 9 in das Abdeckelement 5 eingelegt, wobei die zweite Leiterplatte 9 mit ihrer Oberseite 10 an einer angrenzend zu der Innenumfangsfläche 8 des Abdeckelements 5 ausgebildeten Innenfläche 25 der Deckenwandung 13 mittels einer Klebverbindung, einer Schweißverbindung oder einer Einrastverbindung, wie mit den Pfeilen 21 dargestellt, befestigt wird. Ist die Leiterplatte 9 in das Abdeckelement 5 eingelegt, liegt der an der zweiten Anschlusslasche 17 angeordnete Netzanschluss 20 auf einer die Außenumfangsfläche 6 des Abdeckelementes 5 bildende Seitenwandung 12 auf, wobei in diesem Bereich die Seitenwandung 12 mit einer Aussparung entsprechend der Größe des Netzanschlusses 20 versehen ist. Die Seitenwandung 12 dient dadurch in diesem Bereich als eine Art Abstützung, so dass von der Seitenwandung 12 die an dem Netzanschluss 20 wirkenden Steckkräfte aufgenommen werden können. Die zweite Anschlusslasche 14 ist entlang der Seitenwandung 12, insbesondere der Innenfläche 27 der Seitenwandung 12, geführt, so dass hier die Seitenwandung 12 als eine Art Führung dient.

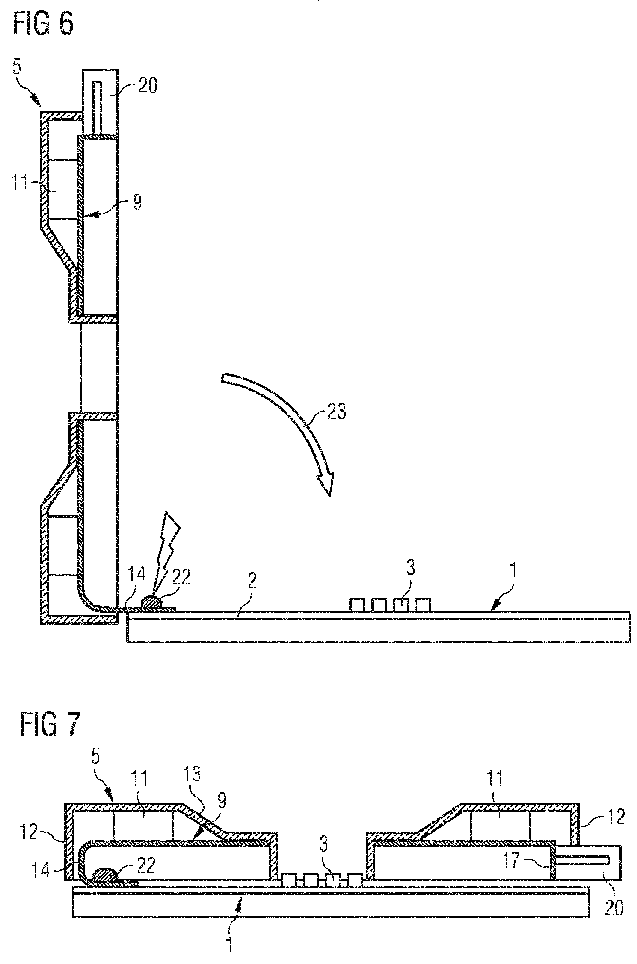

In einem weiteren Montageschritt wird, wie in Figur 6 gezeigt ist, die zweite Leiterplatte 9 zusammen mit dem Abdeckelement 5 an der ersten Leiterplatte 1, an welcher bereits mehrere Lichtquellen 3 angeordnet sind, befestigt und gleichzeitig elektrisch verbunden. Dies erfolgt, indem die erste Anschlusslasche 14 auf der Oberseite 2 der ersten Leiterplatte 1 aufgelötet oder aufgeschweißt wird, wie hier mit dem Verbindungspunkt 22 dargestellt ist. Während des Verbindens, insbesondere des Schweißens oder Lötens, ist die zweite Leiterplatte 9 zusammen mit dem Abdeckelement 5 in einem im Wesentlichen rechten Winkel und damit senkrecht zu der ersten Leiterplatte 1 angeordnet, wie dies in Figur 6 zu erkennen ist.

Ist die zweite Leiterplatte 9 mit der ersten Leiterplatte 1 verbunden, wird durch ein Biegen der ersten Anschlusslasche 14 die zweite Leiterplatte 9 zusammen mit dem Abdeckelement 5 derart nach unten in Richtung der ersten Leiterplatte 1 verschwenkt, mit dem Pfeil 23 angedeutet, dass, in einer wie in Figur 7 gezeigten Endposition, die zweite Leiterplatte 9 parallel zu der ersten Leiterplatte 1 ausgerichtet ist.

Abschließend wird das Abdeckelement 5 mit der ersten Leiterplatte 1 lösbar oder unlösbar, beispielsweise durch eine Klemmverbindung, eine Klebverbindung oder eine Heißverstemmverbindung, verrutschsicher verbunden.

## Patentansprüche

1. Leuchtmodul, mit
• einer ersten Leiterplatte (1), an welcher mindestens eine Lichtquelle (3) angeordnet ist,
• einem Abdeckelement (5), welches die erste Leiterplatte (1) zumindest teilweise abdeckt, und
• einer zweiten Leiterplatte (9), an welcher mindestens ein elektronisches Bauelement (11) angeordnet ist,
• wobei die zweite Leiterplatte (9) an dem Abdeckelement (5) befestigt ist und mit der ersten Leiterplatte (1) elektrisch verbunden ist,
**dadurch gekennzeichnet, dass**
• die zweite Leiterplatte (9) als eine flexible Leiterplatte ausgebildet ist,
• die zweite Leiterplatte (9) einen Grundkörper (15) und eine mit dem Grundkörper (15) verbundene erste gebogene Anschlusslasche (14) aufweist, wobei die zweite Leiterplatte (9) mittels der ersten gebogenen Anschlusslasche (14) mit der ersten Leiterplatte (1) elektrisch verbunden ist.

2. Leuchtmodul gemäß Anspruch 1,
wobei die zweite Leiterplatte (9) mit der ersten Leiterplatte (1) mittels einer Schweißverbindung oder einer Lötverbindung elektrisch verbunden ist.

3. Leuchtmodul gemäß einem der Ansprüche 1 bis 2,
wobei die zweite Leiterplatte (9) eine zweite Anschlusslasche (17) aufweist, an welcher ein Netzanschluss (20) angeordnet ist.

4. Leuchtmodul gemäß einem der Ansprüche 1 bis 3,
wobei das mindestens eine elektronische Bauelement (11) eine oberflächenmontierte Komponente ist.

5. Leuchtmodul gemäß einem der Ansprüche 1 bis 4,
wobei die zweite Leiterplatte (9) mittels einer Schweißverbindung, einer Klebverbindung und/oder einer Einrastverbindung an dem Abdeckelement (5) befestigt ist.

6. Leuchtmodul gemäß einem der Ansprüche 1 bis 5,
wobei das elektronische Bauelement (11) ein Kondensator ist.

7. Leuchtmodul gemäß Anspruch 6,
wobei das als Kondensator ausgebildete elektronische Bauelement (11) aus einem Keramikmaterial ausgebildet ist.

8. Leuchtmodul gemäß einem der Ansprüche 1 bis 7,
wobei das Abdeckelement (5) mit der ersten Leiterplatte (1) lösbar oder unlösbar verbunden ist.

9. Leuchtmodul gemäß einem der Ansprüche 1 bis 7,
wobei das Abdeckelement (5) mit der ersten Leiterplatte (1) lösbar oder unlösbar verbunden ist.

10. Leuchtmodul gemäß einem der Ansprüche 1 bis 9,
wobei die Lichtquelle (3) eine Leuchtdiode ist.

11. Verfahren zur Montage eines Leuchtmoduls, insbesondere nach einem der Ansprüche 1 bis 10, bei welchem
- an einer ersten Leiterplatte (1) mindestens eine Lichtquelle (3) angeordnet wird,
- an einer zweite Leiterplatte (9) mindestens ein elektronisches Bauelement (11) angeordnet wird,
- die mit dem mindestens einen elektronischen Bauelement (11) bestückte zweite Leiterplatte (9) an einem Abdeckelement (5) befestigt wird,
- die zweite Leiterplatte (9) mit der ersten Leiterplatte (1) elektrisch verbunden wird,
- das Abdeckelement (5) auf die erste Leiterplatte (1) derart aufgesetzt wird, dass das Abdeckelement (5) die erste Leiterplatte (1) zumindest teilweise abdeckt,
- die zweite Leiterplatte (9) als eine flexible Leiterplatte ausgebildet ist,
- die zweite Leiterplatte (9) einen Grundkörper (15) und eine mit dem Grundkörper (15) verbundene, erste gebogene Anschlusslasche (14) aufweist, wobei die zweite Leiterplatte (9) mittels der ersten gebogenen Anschlusslasche (14) mit der ersten Leiterplatte (1) elektrisch verbunden ist.

## Claims

1. Lighting module, comprising
• a first printed circuit board (1), on which at least one light source (3) is arranged,
• a covering element (5), which at least partially covers the first printed circuit board (1), and
• a second printed circuit board (9), on which at least one electronic component (11) is arranged,
• wherein the second printed circuit board (9) is fastened to the covering element (5) and is electrically connected to the first printed circuit board (1),
**characterized in that**
• the second printed circuit board (9) is designed as a flexible printed circuit board,
• the second printed circuit board (9) has a basic body (15) and a first bent connection lug (14) which is connected to the basic body (15), wherein the second printed circuit board (9) is electrically connected to the first printed circuit board (1) by means of the first bent connection lug (14).

2. Lighting module according to Claim 1,
wherein the second printed circuit board (9) is electrically connected to the first printed circuit board (1) by means of a welded connection or a soldered connection.

3. Lighting module according to either of Claims 1 and 2,
wherein the second printed circuit board (9) has a second connection lug (17), on which a mains connection (20) is arranged.

4. Lighting module according to one of Claims 1 to 3,
wherein the at least one electronic component (11) is a surface-mounted component.

5. Lighting module according to one of Claims 1 to 4,
wherein the second printed circuit board (9) is fastened on the covering element (5) by means of a welded connection, an adhesive connection and/or a latch-in connection.

6. Lighting module according to one of Claims 1 to 5,
wherein the electronic component (11) is a capacitor.

7. Lighting module according to Claim 6,
wherein the electronic component (11) in the form of a capacitor is formed from a ceramic material.

8. Lighting module according to one of Claims 1 to 7,
wherein the covering element (5) is connected detachably or undetachably to the first printed circuit board (1).

9. Lighting module according to one of Claims 1 to 7,
wherein the covering element (5) is connected detachably or undetachably to the first printed circuit board (1).

10. Lighting module according to one of Claims 1 to 9,
wherein the light source (3) is a light-emitting diode.

11. Method for mounting a lighting module, in particular according to one of Claims 1 to 10, in which
- at least one light source (3) is arranged on a first printed circuit board (1),
- at least one electronic component (11) is arranged on a second printed circuit board (9),
- the second printed circuit board (9), which is populated with the at least one electronic component (11), is fastened on a covering element (5),
- the second printed circuit board (9) is electrically connected to the first printed circuit board (1),
- the covering element (5) is positioned on the first printed circuit board (1) in such a way that the covering element (5) at least partially covers the first printed circuit board (1),
- the second printed circuit board (9) is designed as a flexible printed circuit board,
- the second printed circuit board (9) has a basic body (15) and a first bent connection lug (14) which is connected to the basic body (15), wherein the second printed circuit board (9) is electrically connected to the first printed circuit board (1) by means of the first bent connection lug (14).

## Revendications

1. Module d'éclairage, avec
• une première plaquette de circuits imprimés (1), sur laquelle est disposée au moins une source lumineuse (3),
• un élément de recouvrement (5), qui recouvre au moins en partie la première plaquette de circuits imprimés (1), et
• une deuxième plaquette de circuits imprimés (9), sur laquelle est disposé au moins un composant électronique (11),
• dans lequel la deuxième plaquette de circuits imprimés (9) est fixée à l'élément de recouvrement (5) et est électriquement reliée à la première plaquette de circuits imprimés (1),
**caractérisé en ce que**
• la deuxième plaquette de circuits imprimés (9) est une plaquette de circuits imprimés flexible,
• la deuxième plaquette de circuits imprimés (9) présente un corps de base (15) et une première lamelle de raccordement pliée (14) reliée au corps de base (15), dans lequel la deuxième plaquette de circuits imprimés (9) est reliée électriquement à la première plaquette de circuits imprimés (1) au moyen de la première lamelle de raccordement pliée (14).

2. Module d'éclairage selon la revendication 1, dans lequel la deuxième plaquette de circuits imprimés (9) est électriquement reliée à la première plaquette de circuits imprimés (1) par un assemblage soudé ou un assemblage brasé.

3. Module d'éclairage selon une des revendications 1 à 2, dans lequel la deuxième plaquette de circuits imprimés (9) présente une deuxième lamelle de raccordement (17), sur laquelle est disposée une borne de raccordement au réseau (20).

4. Module d'éclairage selon l'une quelconque des revendications 1 à 3, dans lequel ledit au moins un composant électronique (11) est un composant monté en surface.

5. Module d'éclairage selon l'une quelconque des revendications 1 à 4, dans lequel la deuxième plaquette de circuits imprimés (9) est fixée à l'élément de recouvrement (5) par un assemblage soudé, un assemblage collé et/ou un assemblage par encliquetage.

6. Module d'éclairage selon l'une quelconque des revendications 1 à 5, dans lequel le composant électronique (11) est un condensateur.

7. Module d'éclairage selon la revendication 6, dans lequel le composant électronique (11) conçu comme un condensateur est réalisé en un matériau céramique.

8. Module d'éclairage selon l'une quelconque des revendications 1 à 7, dans lequel l'élément de recouvrement (5) est relié de façon séparable ou inséparable à la première plaquette de circuits imprimés (1).

9. Module d'éclairage selon l'une quelconque des revendications 1 à 7, dans lequel l'élément de recouvrement (5) est relié de façon séparable ou inséparable à la première plaquette de circuits imprimés (1).

10. Module d'éclairage selon l'une quelconque des revendications 1 à 9, dans lequel la source lumineuse (3) est une diode électroluminescente.

11. Procédé de montage d'un module d'éclairage, en particulier selon l'une quelconque des revendications 1 à 10, dans lequel
- au moins une source lumineuse (3) est disposée sur une première plaquette de circuits imprimés (1),
- au moins un composant électronique (11) est disposé sur une deuxième plaquette de circuits imprimés (9),
- la deuxième plaquette de circuits imprimés (9) garnie dudit au moins un composant électronique (11) est fixée à un élément de recouvrement (5),
- la deuxième plaquette de circuits imprimés (9) est reliée électriquement à la première plaquette de circuits imprimés (1),
- l'élément de recouvrement (5) est posé sur la première plaquette de circuits imprimés (1), de telle manière que l'élément de recouvrement (5) recouvre au moins en partie la première plaquette de circuits imprimés (1),
- la deuxième plaquette de circuits imprimés (9) est une plaquette de circuits imprimés flexible,
- la deuxième plaquette de circuits imprimés (9) présente un corps de base (15) et une première lamelle de raccordement pliée (14) reliée au corps de base (15), dans lequel la deuxième plaquette de circuits imprimés (9) est électriquement reliée à la première plaquette de circuits imprimés (1) au moyen de la première lamelle de raccordement pliée (14).
